# EUROPEAN PATENT SPECIFICATION

(11) **EP 0 902 325 B1**
(45) Date of publication and mention of the grant of the patent: **13.03.2002**
(21) Application number: 98116358.7
(22) Date of filing: 28.08.1998
(51) Int. Cl.: G03F 7/021

(54) **Photosensitive composition**
Photoempfindliche Zusammensetzung
Composition photosensible

(30) Priority: 10.09.1997 JP 24547097
(43) Date of publication of application: 17.03.1999
(73) Proprietor: FUJI PHOTO FILM CO., LTD., Kanagawa-ken (JP)
(72) Inventor: Aono, Koichiro, Yoshida-cho, Haibara-gun, Shizuoka (JP)
(74) Representative: HOFFMANN - EITLE

(56) References cited:
- DATABASE WPI Section Ch, Week 9442 Derwent Publications Ltd., London, GB; Class A89, AN 94-335819 XP002104149 & JP 06 258821 A (FUJI PHOTO FILM CO LTD) , 16 September 1994
- PATENT ABSTRACTS OF JAPAN vol. 012, no. 019 (P-657), 21 January 1988 & JP 62 175734 A (FUJI PHOTO FILM CO LTD), 1 August 1987

## Description

The present invention relates to a photosensitive composition suitable for use in the production of lithographic printing plate, IC circuit or photomask. More specifically, it relates to a photosensitive composition comprising a negative-working photosensitive compound and a high molecular weight compound having an excellent abrasion resistance.

In negative-working photosensitive compositions, most of the substances used as a photosensitive substance are diazonium compounds. The most typical example of the photosensitive substance is a diazo resin represented by a formaldehyde condensate of p-diazodiphenylamine.

The composition of a photosensitive layer in a photosensitive lithographic printing plate using a diazo resin can be classified into two groups; a composition comprising a diazo resin alone, i.e., a composition without using a binder, as described in, for example, US Patent 2,714,066; and a composition comprising a mixture of a binder and a diazo resin, as described in, for example, JP-A-50-30604 (the term "JP-A" used herein means an "unexamined published Japanese patent application"). Recently, however, many photosensitive lithographic printing plates using a diazonium compound comprises a polymer comprising a diazonium compound and a binder in order to have a high press life.

The conventional photosensitive layer is a so-called alkali developing type wherein an unexposed portion is eliminated (developed) by an aqueous alkali developer, as described in JP-A-50-30604. However, a polymer obtained by copolymerizing a carboxylic acid-containing monomer has a poor abrasion resistance due to its structure as described in JP-A-50-30604. Thus, only a lithographic printing plate having a low press life has been obtained from such a photosensitive lithographic printing plate which contains a binder and a diazo resin in a photosensitive layer.

The conventional polymer having an excellent abrasion resistance is a polyurethane resin. Further, JP-A-62-123452, 62-123453, 63-287946, 1-134354, 1-255854, 1-271741, 1-293336 and 2-24656 disclose a combination system of a polyurethane resin having a carboxyl group introduced therein and a diazo resin in order to impart an aqueous alkali developing property.

However, when a photosensitive lithographic printing plate is placed in an atmosphere having high temperature and humidity for a long period of time, developing property and press life in a lithographic direct printing (direct lithoprinting) which is a printing severer than usual lithographic printing are not satisfactory, and, therefore, further improvement has been desired.

Accordingly, an object of the present invention is to overcome the above-described problems and to provide a photosensitive composition having highly balanced developing property to an aqueous alkali developer and press life.

More specifically, the object of the present invention is to provide a photosensitive lithographic printing plate having excellent developing property and press life in the direct lithoprinting even if the plate is stored in an atmosphere having high temperature and high humidity.

As a result of extensive studies to achieve the above-described object, it has been found that the object can be achieved by combining constituent components comprising two kinds of diazo resins having different counter anions each other and a polyurethane resin, and their specific proportions. The present invention has been completed based on this finding.

Namely, the present invention exhibits the effect that if two or more kinds of diazo resins having a different polarity each other are used together as diazo resins to be used in combination with an alkali-soluble polyurethane resin, when a photosensitive layer is exposed, the entire layer is photo-cured without forming uneven portions, and light stability of the photosensitive layer is improved even in high temperature and high humidity atmosphere.

More specifically, in accordance with the present invention, there is provided a photosensitive composition comprising a diazo resin (a) wherein a counter anion is an inorganic acid anion or an aliphatic organic acid anion having 3 or less carbon atoms; a diazo resin (b) wherein a counter anion is an aliphatic or aromatic organic acid anion having 6 or more carbon atoms; and a polyurethane resin which is a reaction product of an isocyanate comprising 40 to 90 mol% of a diisocyanate represented by the general formula (I) based on the amount of total isocyanate components with an alcohol comprising 30 to 90 mol% of a diol represented by the general formula (II) based on the amount of total alcohol components. 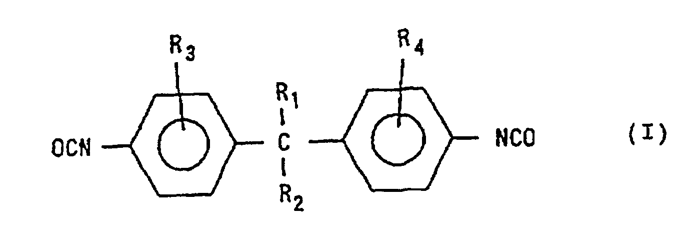 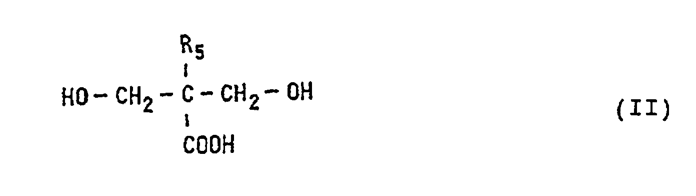 wherein R₁, R₂, R₃ and R₄ may be the same or different and represent a hydrogen atom, an alkyl group having 1 to 4 carbon atoms, an alkoxy group having 1 to 6 carbon atoms or a halogen atom, preferably a hydrogen atom, a methyl group, an ethyl group or a chlorine atom, and more preferably a hydrogen atom or a methyl group; and R₅ represents a hydrogen atom or an alkyl group having 1 to 8 carbon atoms, preferably a hydrogen atom, a methyl group, an ethyl group or a propyl group, and more preferably a hydrogen atom or a methyl group.

Components used in the photosensitive composition of the present invention, the production method of the photosensitive composition of the present invention and the use method thereof will be described in detail below.

### (1) Diazo resin

The diazo resin used in the present invention is a diazo compound represented by a condensate of an aromatic diazonium salt and a compound containing an active carbonyl group (e.g., formaldehyde), a co-condensed diazo resin comprising, as constituent units, an aromatic compound having at least one group of a carboxyl group, a sulfonic group, a sulfinic group, an oxyacid group of phosphorus and a hydroxyl group, and an aromatic diazonium compound; or a co-condensed diazo resin comprising, as constituent units, an aromatic compound having an aromatic amine, phenol, a phenol ether, an aromatic thioether, an aromatic hydrocarbon, an aromatic heterocyclic compound or an organic acid amide, and an aromatic diazonium compound.

Examples of an inorganic acid or an aliphatic organic acid having 3 or less carbon atoms, for forming a counter anion of the diazo resin (a) include hexafluorophosphoric acid, tetrafluoroboric acid, phosphoric acid, phosphotungstic acid, thiocyanic acid, methanesulfonic acid, ethanesulfonic acid, propanesulfonic acid, trifluoromethanesulfonic acid, and the mixtures thereof. Of those, hexafluorophosphoric acid and tetrafluoroboric acid are preferable.

Examples of an aliphatic or an aromatic organic acid having 6 or more carbon atoms, for forming a counter anion of the diazo resin (b) include 2-hydroxy-4-methoxybenzophenone-5-sulfonic acid, 5-sulfosalicylic acid, paratoluenesulfonic acid, laurylsulfonic acid, dioctylsulfosuccinic acid, dicyclohexylsulfosuccinic acid, camphor sulfonic acid, tolyloxy-3-propanesulfonic acid, nonylphenoxy-3-propanesulfonic acid, nonylphenoxy-4-butanesulfonic acid, dibutylphenoxy-3-propanesulfonic acid, diamylphenoxy-3-propanesulfonic acid, dinonylphenoxy-3-propanesulfonic acid, dibutylphenoxy-4-butanesulfonic acid, dinonylphenoxy-4-butanesulfonic acid, benzenesulfonic acid, mesitylenesulfonic acid, p-chlorobenzenesulfonic acid, 2,5-dichlorobenzenesulfonic acid, 2,5-dimethylbenzenesulfonic acid, p-acetylbenzenesulfonic acid, 5-nitro-o-toluenesulfonic acid, 2-nitrobenzenesulfonic acid, 3-chlorobenzenesulfonic acid, 3-bromobenzenesulfonic acid, 2-chloro-5-nitrobenzenesulfonic acid, butylbenzenesulfonic acid, octylbenzenesulfonic acid, decylbenzenesulfonic acid, dodecylbenzenesulfonic acid, butoxybenzenesulfonic acid, decyloxybenzenesulfonic acid, 2-methoxy-4-hydroxy-5-benzoylbenzenesulfoninc acid, isopropylnaphthalenesulfonic acid, butylnaphthalenesulfonic acid, hexylnaphthalenesulfonic acid, octylnaphthalenesulfonic acid, butoxynaphthalenesulfonic acid, dodecyloxynaphthalenesulfonic acid, dibutylnaphthalenesulfonic acid, dioctyl naphthalenesulfonic acid, triisopropylnaphthalenesulfonic acid, tributylnaphthalenesulfonic acid, 1-naphthol-5-sulfonic acid, naphthalene-1-sulfonic acid, naphthalene-2-sulfonic acid, 1,8-dinitronaphthalene-3,6-disulfonic acid, 4,4'-diazide-stilben-3,3'-disulfonic acid, 1,2-naphthoquinone-2-diazide-4-sulfonic acid, 1,2-naphthoquinone-2-diazide-5-sulfonic acid, 1,2-naphthoquinone-1-diazide-4-sulfonic acid and the mixtures thereof. Of those, dodecylbenzenesulfonic acid, dibutylnaphthalenesulfonic acid and octylnaphthalenesulfonic acid are preferable.

In the present invention, weight ratio of the diazo resin (a) wherein a counter anion is an inorganic acid anion or an aliphatic organic acid anion having 3 or less carbon atoms and the diazo resin (b) wherein a counter anion is an aliphatic or aromatic organic acid anion having 6 or more carbon atoms is preferably 0.1 : 0.9 to 0.9 : 0.1, and more preferably 0.2 : 0.8 to 0.8 : 0.2. If the ratio of the diazo resin (a) is below 0.1 ( if the ratio of the diazo resin (b) is more than 0.9), adhesiveness of a photosensitive layer to a support is poor, so that the press life thereof is decreased. On the other hand, if the ratio of the diazo resin (a) is more than 0.9 (if the ratio of the diazo resin (b) is below 0.1), abrasion resistance of a photosensitive layer is poor, so that the press life thereof is decreased.

### (2) Polyurethane resin

The polyurethane resin suitably used in the present invention is a polyurethane resin having, as a basic skeleton thereof, a structure represented by a reaction product of a diisocyanate compound represented by the following general formula (I) with a diol compound represented by the following general formula (II). 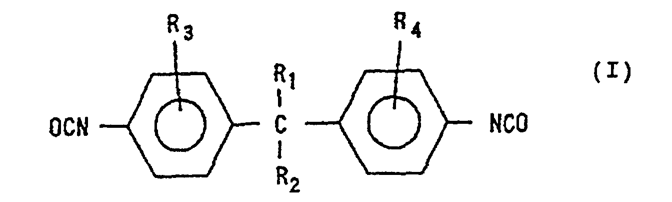 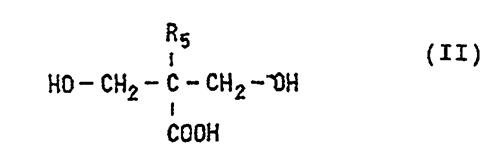 wherein R₁ to R₅ are the same as defined above. The typical examples of the diisocyanate compound represented by the general formula (I) are 4,4'-diphenylmethane diisocyanate and 4,4'-(2,2-diphenylpropane) diisocyanate. Further, if required, in addition to the diisocyanate compound represented by the general formula (I), the following diisocyanate compounds can be used together within the preferred compositional range of the present invention.

Examples of the diisocyanate compounds used together are aromatic diisocyanate compounds such as 2,4-tolylene diisocyanate, a dimer of 2,4-tolylene diisocyanate, 2,6-tolylene diisocyanate, p-xylylene diisocyanate, m-xylylene diisocyanate, 4,4'-diphenylmethane diisocyanate, 1,5-naphthylene diisocyanate or 3.3'-dimethylbiphenyl-4.4'-diisocyanate; aliphatic diisocyanate compounds such as hexamethylene diisocyanate, trimethylhexamethylene diisocyanate, lysine diisocyanate or dimer acid diisocyanate; alicyclic diisocyanate compounds such as isophorone diisocyanate, 4,4'-methylenebis (cyclohexylisocyanate), methylcyclohexane-2,4 (or 2,6) diisocyanate or 1,3-(isocyanatemethyl) cyclohexane; diisocyanate compounds which are reaction products of diisocyanate with diol, such as an addition product of 1 mol of 1,3-butylene glycol and 2 mols of tolylene diisocyante.

Of the above compounds, preferable diisocyanate compounds used together with the diisocyanate compound represented by the general formula (I) are hexamethylene diisocyanate, isophorone diisocyante and m-xylylene diisocyanate. Further, two kinds or more of the above-described diisocyanate compounds can be used in combination with the diisocyanate having the general formula (I).

On the other hand, typical examples of the diol compounds having a carboxyl group represented by the general formula (II) include 2,2-bis(hydroxylmethyl) acetic acid, 2,2-bis(hydroxylmethyl) propionic acid and 2,2-bis(hydroxylmethyl) butyric acid. Of those, 2,2-bis(hydroxylmethyl) propionic acid is preferable.

Examples of the diol compounds used together with the diol compound having the general formula (II) include diethylene glycol, triethylene glycol, tetraethylene glycol, polyethylene glycol, 1,2-dipropylene glycol, 1,2-tripropylene glycol, 1,2-tetrapropylene glycol, 1,3-dipropylene glycol and 1,3-dibuylene glycol. Of those, diethylene glycol, triethylene glycol, tetraethylene glycol, 1,2-tripropylene glycol and 1,2-tetrapropylene glycol are preferable, and triethylene glycol and tetraethylene glycol are more preferable.

The polyurethane resin suitably used in the present invention contains a diisocyanate compound represented by the general formula (I) in an amount of 40 to 90 mol%, preferably 50 to 85 mol%, and more preferably 60 to 80 mol%, of the amount of total isocyanate components. The remaining component used is the above-described diisocyanate compounds used together with the diisocyanate compound of the general formula (I).

The amount of the diol compound represented by the general formula (II) is 30 to 90 mol%, preferably 40 to 80 mol%, and more preferably 50 to 70 mol%, of the amount of the total diol components. The remaining component used is the above-described diol compounds used together with the diol compound of the general formula (II). Two or more kinds of the above-described diol compounds may be used in combination with the diol compound of the general formula (II).

The above-described polyurethane resin suitably used in the present invention has a weight average molecular weight (polystyrene basis) of preferably 40,000 or more. Generally, if a molecular weight is high, press life is excellent, but developing property is decreased. On the other hand, if a molecular weight is low, developing property is improved, but press life is decreased. In the polyurethane resin having the composition of the present invention, where the weight average molecular weight is less than 40,000, problems unfavorably occur in deterioration of press life. The weight average molecular weight is preferably 50,000 to 500,000, and more preferably 70,000 to 200,000. In such a case, a degree of dispersion (Mw/Mn) is 20 or less, preferably 16 or less, and more preferably 14 or less. If the degree of dispersion is more than 20, a significant amount of a low molecular weight component having a weight average molecular weight of less than 40,000 is present, which may cause the problem in the deterioration of press life.

The content of the polyurethane resin in the photosensitive composition according to the present invention is 50 to 97% by weight, and preferably 70 to 95% by weight, in terms of solid content conversion. The polyurethane resin of the present invention is synthesized by heating the above-described diisocyanate compounds and diol compounds in an aprotic solvent to which conventional catalysts having an activity corresponding to the respective reactivity of those compounds are added. The molar ratio of the diisocyanate and diol compound used is preferably 0.8 : 1 to 1.2 : 1. When an isocyanate group remains in the end of a polymer, treatment with alcohols or amines conducted so that the resin is finally synthesized in the form free from residual isocyanate groups.

The weight ratio of the diazo resin and the polyurethane resin is preferably 3 : 97 to 30 : 70, and more preferably 5 : 95 to 25 : 75.

### (3) Other components

The composition of the present invention can contain, in addition to the above-described polyurethane resin, conventional alkali-soluble high molecular weight compounds such as phenol-formaldehyde resin, cresol-formaldehyde resin, phenol-modified xylene resin, polyhydroxy styrene, polyhalogenated hydroxystyrene, carboxyl group-containing epoxy resin, polyacetal resin, acrylic resin and methacrylic resin. Such alkali-soluble high molecular weight compounds can be used in an amount of 70% by weight or less based on the weight of the total composition.

The composition of the present invention can further contain printing-out agents for obtaining a visible image immediately after exposure, dyes as an image-coloring agent, pigments, stabilizers, surfactants, plasticizers, ink receptivity agents and other fillers. Representative example of the printing-out agent for obtaining a visible image immediately after exposure is a combination of a photosensitive compound releasing an acid upon exposure and an organic dye capable of forming a salt. Specific examples of such a combination include a combination of o-naphthoquinonediazide-4-sulfonic halide and a salt-forming organic dye as described in JP-A-50-36209 and 53-8128; and a combination of a trihalomethyl compound and a salt-forming organic dye as described in JP-A-53-36223 and 54-74728.

Dyes other than the above-described salt-forming organic dyes can be used as the image coloring agent. Preferable dyes including salt-forming organic dyes include oil-soluble dyes and basic dyes. Specific examples of the dye include Oil Yellow #101, Oil Yellow #130, Oil Pink #312, Oil Green BG, Oil Blue BOS, Oil Blue #603, Oil Black BY, Oil Black BS, Oil Black T-505 (these are produced by Orient Chemical Industry K.K.), Victoria Pure Blue, Crystal Violet (CI42555), Methyl Violet (CI42535), Rhodamine B (CI45170B), Malachite Green (CI42000) and Methylene Blue (CI52015).

Examples of the stabilizer include phosphoric acid, phosphorous acid, oxalic acid, p-toluene sulfonic acid, dipicolinic acid, malic acid, tartaric acid, 2-methoxy-4-hydroxy-5-benzoyl-benzene sulfonic acid, butyl naphthalene sulfonic acid, p-hydroxybenzene sulfonic acid, 4-sulfophthalic acid, tricarbaric acid and phenyl phosphonic acid.

The surfactant is preferably fluorine surfactants or silicone surfactants.

Examples of the plasticizer include tricresyl phosphate, dihexyl phthalate, dioctyl phthalate, trioctyl phosphate, tributyl phosphate, tributyl citrate, polyethylene glycol and polypropylene glycol.

The ink receptivity agent is preferably those described in JP-B-62-60701 and JP-A-63-262642.

Further, a developing accelerator (for example, higher alcohols, acid anhydrides.) is also preferably used in the composition of the present invention.

Amount of those additives added differs depending upon a field to which the composition is used and the purpose of use of the composition, but the amount is generally 0.01 to 30% by weight based on the weight of solid content of a photosensitive composition.

The composition of the present invention is dissolved in a solvent which can dissolve the above-described each component and the resulting solvent solution is coated on a support. Examples of the solvent which can be used include methanol, ethanol, isopropanol, n-butanol, t-butanol, ethylenedichloride, cyclohexanone, methyl ethyl ketone, ethylene glycol, ethylene glycol monomethyl ether, ethylene glycol monoethyl ether, 2-methoxyethyl acetate, 1-methoxy-2-propanol, 1-methoxy-2-propyl acetate, methyl lactate, ethyl lactate, N,N-dimethyl formamide, N,N-dimethyl acetamide, γ-butyrolactone, N-methyl pyrrolidone, tetramethyl urea, tetrahydrofuran, dioxane, dimethyl sulfoxide, sulfolane, toluene and ethyl acetate. These solvents can be used alone or as mixtures thereof. The concentration (solid content) of the above-described components is 2 to 50% by weight. Further, the coating amount differs depending upon the purpose of use of the composition. For example, where the composition is used for a photosensitive lithographic printing plate, the concentration is generally 0.5 to 3.0 g/m² as a solid content. The photosensitivity increases as the coating amount decreases, but physical properties of the photosensitive film decrease.

The support on which the photosensitive composition of the present invention is coated include papers, papers having plastics (for example, polyethylene, polypropylene or polystyrene) laminated thereon; plates of metals such as aluminum (including aluminum alloy), zinc or copper; films of plastics such as cellulose diacetate, cellulose triacetate, cellulose propionate, cellulose butylate, cellulose acetate butylate, cellulose nitrate, polyethylene terephthalate, polyethylene, polystyrene, polypropylene, polycarbonate or polyvinyl acetal; papers or plastic films having the above-described metals laminated or deposited thereon. Of those supports, an aluminum plate is extremely stable in dimension and also inexpensive, and is therefore particularly preferable. Further, a composite sheet wherein an aluminum sheet is bonded on a polyethylene terephthalate film as described in JP-B-48-18327 is also preferably used.

The surface of an aluminum material is desirably treated in order to enhance water retention and improve adhesiveness to a photosensitive layer. For example, the surface treatment method is a method for roughening the surface. The surface roughening method generally includes conventional methods such as brush abrasion, ball abrasion, electrolytic etching, chemical etching, liquid honing, sandblast and the combinations thereof. Of those, the brush abrasion method, the electrolysis etching method, the chemical etching method and the liquid honing method are preferred. Of those methods, a surface roughening method including use of electrolytic etching is particularly preferable. Further, a method that electrolytic etching is conducted after brush abrasion as described in JP-A-54-63902 is also preferably used. An electrolytic bath used in the electrolytic etching is an aqueous solution containing an acid, an alkali or the salts thereof or an aqueous solution containing an organic solvent. Of those, an electrolyte containing hydrochloric acid, nitric acid or the salt thereof is preferable. If required and necessary, the aluminum plate having been subjected to a surface roughening treatment is further subjected to a desmut treatment with an aqueous acid or alkali solution.

The aluminum plate thus obtained is preferably subjected to an anodization treatment. The preferable treatment is a treatment method with a bath containing sulfuric acid or phosphoric acid. Further, if required and necessary, the aluminum plates may preferably be subjected to the following treatments: a silicate (sodium silicate, potassium silicate) treatment described in US Patents 2,714,066 and 3,181,461; a potassium zirconium fluoride treatment described in US Patent 2 ,946,638; a phosphomolybdenum treatment described in US Patent 3,201,247; an alkyl titanate treatment described in UK Patent 1,108,559; a polyacrylic acid treatment described in German Patent 1,091.433; a polyvinyl phosphonic acid treatment described in German Patent 1,134,093 and UK Patent 1,230,447; a phosphonic acid treatment described in JP-B-44-6409; a phytinic acid treatment described in US Patent 3,307,951; a treatment with a salt of hydrophilic organic polymer compound and a divalent metal described in JP-A-58-16893 and 58-18291; a hydrophilic treatment by prime-coating a water-soluble polymer having a sulfonic group described in JP-A-59-101651. Further, the aluminum plate subjected to coloring with an acidic dye described in JP-A-60-64352 is especially preferable. Other hydrophilic treatment methods include a silicate electrodeposition described in US Patent 3,658,662. Further, the aluminum plate which has been subjected to a pore-sealing treatment after graining treatment and anodization is preferable. Such a pore-sealing treatment is conducted by immersing the plate in a hot water or a hot aqueous solution containing an inorganic salt or organic salt, or by steam bathing.

The support suitable for use in the present invention is described in more detail below.

An IS aluminum plate containing iron 0.1- 0.5%, silicone 0.03-0.3%, copper 0.001-0.03% and titanium 0.002-0.1% is immersed in an alkali, preferably an aqueous solution of 1-30% sodium hydroxide, potassium hydroxide, sodium carbonate or sodium silicate at 20 to 80°C for 5 to 250 seconds to conduct etching. Aluminum ion may be added to the etching bath in an amount of about 1/5 of the alkali. The resulting aluminum plate having been subjected to the etching treatment is then immersed in 10 to 30% nitric acid or sulfuric acid aqueous solution at 20 to 70°C for 5 to 250 seconds to conduct neutralization after the alkali etching, and smut removal. After the surface-cleaning of this aluminum alloy plate, surface-roughening treatment is conducted. Suitable surface-roughening treatment is brush abrasion and/or electrolytic etching. The brush abrasion preferably uses pumice stoneaqueous suspension and a nylon brush to give an average surface roughness of 0.25 to 0.9 µ. An electrolyte used in the electrolytic etching treatment is an aqueous solution of hydrochloric acid or nitric acid. The concentration of the solution is preferably 0.01 to 3% by weight, and more preferably 0.05 to 2.5% by weight. If required and necessary, the electrolyte may contain corrosion inhibitors (or stabilizers) such as nitrate, chloride, monoamines, diamines, aldehydes, phosphoric acid, chromic acid, boric acid and ammonium oxalate, a grain uniforming agent, and the like. Further, the electrolyte may contain an appropriate amount of aluminum ion (1 to 10 g/liter).

The electrolytic etching treatment is generally conducted at an electrolyte temperature of 10 to 60°C. The alternating current used in this treatment can be any of rectangular wave, trapezoidal wave and sine wave so long as positive and negative polarities are alternately interchanged. Single phase current and three-phase current of usual commercial alternating current can be used. Further, the treatment is desirably conducted at a current density of 5 to 100 A/dm² for 10 to 300 seconds. The surface roughness of the aluminum alloy support in the present invention is controlled by an electrical amount to be 0.2 to 0.8 µm. Such a grained aluminum alloy is desirably subjected to removal of smut adhered on the surface and etching (preferably in the range of 0.01 to 2.0 g/m²) using 10 to 50% hot sulfuric acid (40 to 60°C) or dilute alkali (sodium hydroxide, etc.). Where removal of the smut and etching is carried out with an alkali, the support is subsequently immersed in an acid (nitric acid or sulfuric acid) for washing to neutralize it. After removal of the smut on the surface, an anodized film is provided. Anodization method can be conducted according to the conventional method. According to this method, sulfuric acid is used as the most useful electrolyte. Phosphoric acid is also a next useful electrolyte. Further, a mixed acid of sulfuric acid and phosphoric acid described in JP-A 55-28400 is also useful.

In the sulfuric acid method, the treatment is generally conducted using direct current. However, alternating current can also be used. The electrolysis treatment is conducted in a sulfuric acid concentration of 5 to 30% at 20 to 60°C for 5 to 250 seconds, whereby an oxide layer of 1 to 10 g/m² is provided on the surface. In this electrolyte solution, aluminum ion is preferably included. The current density at that time is preferably 1 to 20 A/dm². In the case of a phosphoric acid method, the treatment is conducted under the following conditions: phosphoric acid concentration 5 to 50%, temperature 30 to 60°C, time 10 to 300 seconds and current density 1 to 15 A/dm². The aluminum support thus treated is desirably treated on its surface with silicates as described in US Patent 2,714,066. Further, an undercoating may be applied to the aluminum support.

Preferred examples of the compound used for the undercoating include carboxymethyl cellulose; dextrin; gum arabic; amino group-containing phosphonic acids such as 2-aminoethyl phosphonic acid; organic phosphonic acids which may have substituents, such as phenyl phosphonic acids, naphthyl phosphonic acid, alkyl phosphonic acid, glycerophosphonic acid, methylenediphosphonic acid and ethylenediphosphonic acid; organic phosphoric acids which may have substituents, such as phenyl phosphoric acid, naphthyl phosphoric acid, alkyl phosphoric acid and glycerophosphoric acid; organic phosphinic acids which may have substituents, such as phenyl phosphinic acid, naphthyl phosphinic acid, alkyl phosphinic acid and glycerophosphinic acid; amino acids such as glycine and alanine; hydrochlorides of amine having hydroxyl groups, such as hydrochloride of triethanol amine; water-soluble polymers having a sulfonic group as described in JP-A-59-101651; and acidic dyes as described in JP-A-60-64352. This undercoat layer can be provided by dissolving the above-described compounds in water, methanol, ethanol, methyl ethyl ketone or the mixture thereof, and coating the resulting solution on a support, followed by drying. Further, in order to improve a tone reproduction property of a photosensitive lithographic printing plate, a yellow dye can be added. A coated amount of the undercoat layer after drying is suitably 2 to 200 g/m², and preferably 5 to 100 g/m².

A matte layer constructed by projections which are alternately and independently arranged is preferably provided on a photosensitive layer. The object for providing the matte layer is to improve vacuum adhesion between a negative image film and a photosensitive lithographic printing plate in contact exposure, thereby shortening a vacuum suction time, and also to prevent fine halftone dots from plugging in exposing due to poor contact. A method for coating the matte layer includes a method of fusion-bonding a solid powder as described in JP-B-62-62337; and a method comprising spraying polymercontaining water and then drying as described in JP-A-50-125805, JP-B-57-6582, JP-B-61-28986 and JP-B-3-21902. Any of these methods can be used. The matte layer is preferably comprised of a material which dissolves in an aqueous developer substantially free from a solvent or which can be removed by the developer.

The photosensitive lithographic printing plate having a photosensitive composition layer coated on a roughened aluminum plate and then dried gives a relief image negative to an original image by developing using an aqueous alkali solution type developer after an image exposure. A suitable light source for exposure is carbon arc lamp, mercury vapor lamp, xenon lamp, metal halide lamp, strobo, ultraviolet ray and laser beam. The aqueous alkali solution type developer used in the development of the above-described photographic lithographic printing plate is those as described in JP-A-51-77401, 51-80228, 53-44202 and 55-52054. A developer having pH of 8 to 13 and containing 75% by weight or more of water is preferable. If required and necessary, the following materials can be added: an organic solvent having a solubility in water of 10% by weight or less at ordinary temperature, such as benzyl alcohol or ethylene glycol monophenylether; an alkali agent such as triethanol amine, diethanol amine, monoethanol amine, sodium phosphate or sodium carbonate; an anionic surfactant such as an aromatic sulfonate, a dialkylsulfosuccinate, an alkylnaphthalene sulfonate, an aliphatic acid salt or an alkyl sulfate; a nonionic surfactant such as a polyoxyethylene alkylether, a plyoxyethylene alkylarylether or a polyoxyethylene polyoxypropylene block polymer; a scum prevention agent such as sodium sulfite or sodium salt of sulfopyrazorone; and a hard water softening agent such as tetrasodium salt of ethylenediamine tetraacetic acid or trisodium salt of nitrilotriacetic acid.

A photosensitive lithographic printing plate using the photosensitive composition of the present invention can of course be subjected to a plate-making processing according to each method described in JP-A-54-8002, 55-115054 and 59-58431. Namely, after developing treatment, the plate may be washed with water and then subjected to a desensitizing treatment; may be directly subjected to a desensitizing treatment; may be subjected to a treatment with an aqueous solution containing an acid; or may be subjected to a treatment with an aqueous solution containing an acid and then a desensitizing treatment. Further, in the developing process of this kind of photosensitive lithographic printing plate, an aqueous alkali solution is consumed corresponding to the treatment amount so that the alkali concentration is decreased, or the alkali concentration is decreased by air due to a long time operation of an automatic developer, and as a result, the processing capability is decreased. In such a case, fresh unused developer (replenisher) may be added or a replenisher having a high alkalinity may be used to recover the processing capability as described in JP-A-54-62004. In such a case, replenishment may be conducted by a method of adding a replenisher in an amount proportional to the length of one side of PS printing plate or a method described in US Patent 4,882,246.

The above-described plate-making processing is preferably conducted by automatic developing machine as described in JP-A-2-7054 and 2-32357. A desensitizing rubber optionally coated in a final step of the plate-making processing is preferably those described in JP-B-62-16834, JP-B-62-25118, JP-B-63-52600, JP-A-62-7595, JP-A-62-11693 and JP-A-62-83194.

The photosensitive composition of the present invention has an excellent developing property in developing with an aqueous alkali developer. The relief image obtained has good abrasion resistance and adhesion with a support. Further, when it is used as a printing plate, many good printed matters can be obtained.

In particular, developing property after being stored under high temperature and humidity conditions, and press life of direct lithoprinting are excellent.

The present invention will be further described in more detail by reference to the following Synthesis Examples and Examples, but the present invention is not limited thereto.

### SYNTHESIS EXAMPLE 1

To 500 ml three-necked round-bottomed flask equipped with a condenser and a stirrer were added 17.4 g (0.13 mol) of 2,2-bis (hydroxymethyl) propionic acid and 13.6 g (0.070 mol) of tetraethylene glycol, which were dissolved in 120 ml of N,N-dimethyl acetamide. 37.5 g (0.15 mol) of 4,4'-diphenylmethane diisocyanate and 8.4 g (0.050 g) of hexamethylene diisocyanate were further added to the flask, and the resulting mixture was stirred under heating at 100°C for 8 hours. The mixture thus obtained was diluted with 120 ml of N,N-dimethylformamide and 60 ml of methanol. The resulting reaction solution was introduced into 4 liters of water with stirring to precipitate white polymer. This polymer was filtered off, washed with water and dried under vacuum to obtain 73 g of the polymer.

As a result of measurement of its molecular weight with a gel permeation chromatography (GPC), it was 85,000 in terms of weight average molecular weight (polystyrene basis) and the degree of dispersion was 4.1. Further, as a result of measurement of carboxyl group content (acid value) by titration, it was found to be 1.64 meg/g (polyurethane resin of the present invention).

### SYNTHESIS EXAMPLES 2 TO 11

A polyurethane resin of the present invention was synthesized using isocyanate compounds and diol compounds shown in Table 1 in the same manner as in Synthesis Example 1.

The molecular weight was measured by GPC and the acid value was measured by titration. The acid value and molecular weight measured, and the degree of dispersion are shown in Table 1 below. The molecular weight is all represented in terms of weight average basis (polystyrene basis).

**TABLE 1**

| Polyurethane resin | Diisocyanate compound used | Diol compound used | Acid value | Molecular weight | Degree of dispersion |
|---|---|---|---|---|---|
| | (mol%) | (mol%) | (meq/g) | (x10⁴) | |
| 2 | (1) + (2) (70) (30) | (1) + (2) (60) (40) | 1.61 | 9.3 | 4.5 |
| 3 | (1) + (3) (80) (20) | (1) + (3) (65) (35) | 1.60 | 9.5 | 4.0 |
| 4 | (1) + (4) (75) (25) | (1) + (3) (60) (40) | 1.51 | 8.2 | 3.8 |
| 5 | (1) + (2) (80) (20) | (1) + (4) (70) (30) | 1.77 | 7.3 | 3.6 |
| 6 | (1) + (2) (80) (20) | (1) + (3) (65) (35) | 1.64 | 9.2 | 4.4 |
| 7 | (1) + (3) (80) (20) | (1) + (2) (70) (30) | 1.79 | 8.9 | 4.2 |
| 8 | (1) + (2) (70) (30) | (1) + (5) (70) (30) | 1.93 | 10.4 | 5.2 |
| 9 | (5) + (2) (75) (35) | (1) + (6) (70) (30) | 1.88 | 7.2 | 3.6 |
| 10 | (1) + (4) (75) (25) | (1) + (2) (65) (35) | 1.79 | 8.5 | 4.3 |

Diisocyanate compounds used:

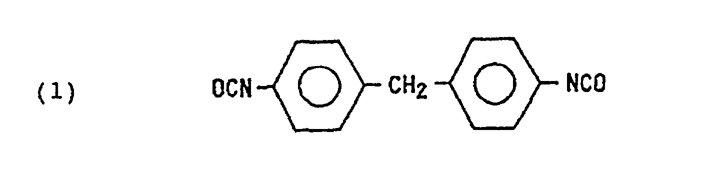

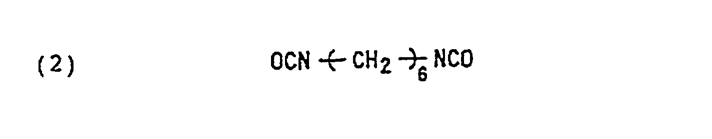

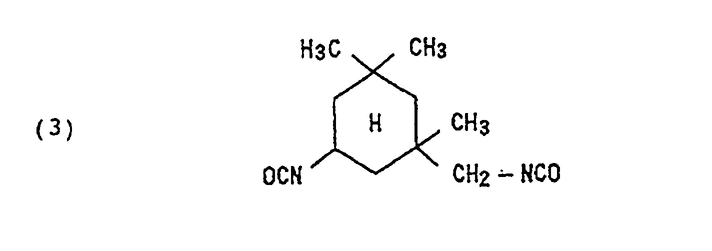

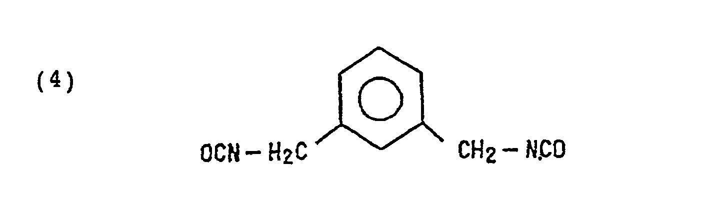

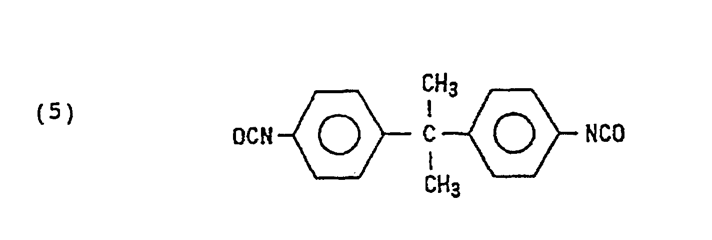

Diol compounds used:

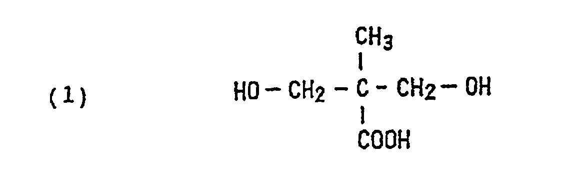

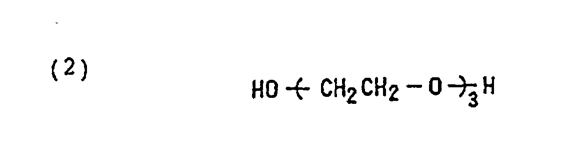

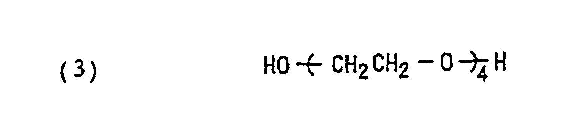

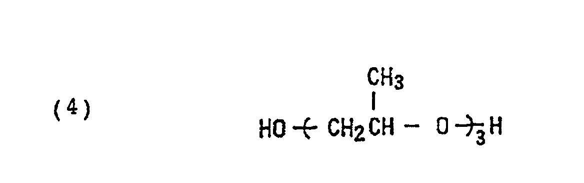

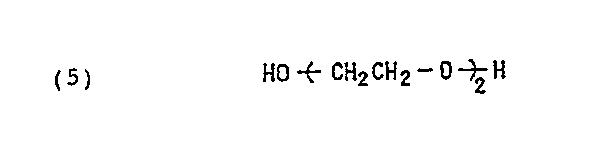

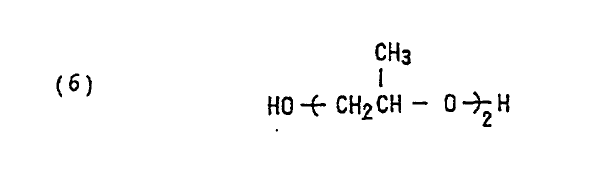

### EXAMPLES 1 TO 5

The surface of an aluminum plate having a thickness of 0.24 mm was grained using a nylon brush and an aqueous suspension of 400 mesh pumice stone, and then adequately washed with water. The resulting plate was immersed in 10% sodium hydroxide aqueous solution at 70°C for 60 seconds to conduct etching, and washed with running water. The plate was neutralized with 20% nitric acid. The plate was then subjected to an electrochemical roughening method described in JP-A-53-67507, i.e., an electrolytic roughening treatment in 1% nitric acid aqueous solution with an electrical quantity at anode of 160 coulomb/dm² using a sinusoidal wave alternating current (V_{A} = 12.7 V, V_{C} = 9.1 V). The plate thus treated was immersed in 30% sulfuric acid aqueous solution to conduct desmut at 55°C for 2 minutes and then subjected to an anodization in 7% sulfuric acid aqueous solution such that the coated amount of aluminum hydroxide was 2.0 g/m². The resulting aluminum plate was immersed in 3% sodium silicate aqueous solution at 70°C for 1 minute, followed by washing with water and drying. The aluminum plate thus obtained was coated with the following photosensitive liquid using a whirler, followed by drying at 80°C for 2 minutes. The dry weight was 1.6 g/m².

| Photosensitive composition | |
|---|---|
| Diazo resin-1 | 0.35 g |
| Diazo resin-2 | 0.15 g |
| Polyurethane resin of Synthesis Example 1 | 5.00 g |
| Stylite HS-2 (Daido Kogyo K.K.) | 0.10 g |
| Victoria Pure Blue-BOH | 0.15 g |
| Tricresyl phosphate | 0.50 g |
| Dipicolinic acid | 0.20 g |
| FC-430 (surfactant produced by 3M) | 0.05 g |

| Solvent | |
|---|---|
| 1-Methoxy-2-propanol | 25.00 g |
| Methyl lactate | 12.00 g |
| Methanol | 30.00 g |
| Methyl ethyl ketone | 30.00 g |
| Water | 3.00 g |

The diazo resin-1 is hexafluorophosphate of a condensate of p-diazodiphenylamine and paraformaldehyde as described in Synthesis Example 1 of JP-A-59-78340. The diazo resin-2 is dodecylbenzene sulfonate of a condensate of p-diazodiphenylamine and paraformaldehyde. Stylite HS-2 (a product of Daido Kogyo K.K.) is a high molecular weight compound having a ink receptivity higher than that of a binder, and is a copolymer of styrene/mono-4-methyl-2-pentyl maleate (50/50 in molar ratio). The copolymer has an average molecular weight of about 100,000. This photosensitive lithographic printing plate was placed into a high temperature and humidity thermostatic chamber of 45°C and 75% for 3 days, imagewise exposed, and then developed with a liquid obtained by diluting DN-3C (aqueous alkali type developer, produced by Fuji Photo Film Co., Ltd.) with water (1 : 1) using 800H (automatic developing machine, manufactured by Fuji Photo Film Co., Ltd.). Immediately thereafter, a liquid obtained by diluting FN-2 (gum solution, produced by Fuji Photo Film Co., Ltd.) with water (1 : 1) was coated on the plate and dried.

The diazo resin, remaining film of dye and remaining color were not present on a part corresponding to a non-image area, and a lithographic printing plate having a bright and beautiful blue image was obtained. In the following Examples and Comparative Examples, such a degree of development is evaluated as "○" .

This plate was cut into 2 pieces by a guillotine cutter. One piece was attached to a direct lithographic system printer (manufactured by Davidson) which was not a conventional off-set system, and printing was conducted at a rate of 4,000 sheets/hour using the commercially available ink (Web King, produced by Toyo Ink K.K.) and the commercially available dampening water (Alkee, produced by Toyo Ink K.K.; 1 : 200 dilution). 60,000 Prints having an adequate concentration of the ink were obtained. In the following Examples and Comparative Examples, this is described as "press life in direct lithoprinting: 60,000 sheets". Another piece was attached to a Halis Oleria printer (manufactured by Halis corporation), and printing was conducted at a rate of 6,000 sheets/hour. 150,000 Prints having an adequate concentration of the ink were obtained. In the following Examples and Comparative Examples, this is described as "press life in offset printing: 150,000 sheets".

### EXAMPLES 2 TO 12

Printing plates were produced using the polyurethane resin used in Example 1 and various kinds of diazo resins in the same manner as in Example 1. The developing property in a high temperature and humidity thermostatic chamber and press life in direct lithoprinting and offset printing were examined. The results obtained are shown in Tables 2 and 3 below.

**TABLE 2**

| | Diazo resin (a) | | Diazo resin (b) | | Polyurethane resin | |
|---|---|---|---|---|---|---|
| Ex. | Kind | Amount(g) | Kind | Amount(g) | Kind | Amount(g) |
| 2 | 1 | 0.05 | 2 | 0.45 | 1 | 5.00 |
| 3 | 1 | 0.25 | 2 | 0.25 | 1 | 5.00 |
| 4 | 1 | 0.40 | 2 | 0.10 | 1 | 5.00 |
| 5 | 1 | 0.45 | 2 | 0.05 | 1 | 5.00 |
| 6 | 1 | 0.35 | 3 | 0.15 | 1 | 5.00 |
| 7 | 1 | 0.35 | 4 | 0.15 | 1 | 5.00 |
| 8 | 5 | 0.35 | 4 | 0.15 | 1 | 5.00 |
| 9 | 1 | 0.35 | 6 | 0.15 | 1 | 5.00 |
| 10 | 7 | 0.35 | 6 | 0.15 | 1 | 5.00 |
| 11 | 1 | 0.35 | 8 | 0.15 | 1 | 5.00 |
| 12 | 9 | 0.35 | 8 | 0.15 | 1 | 5.00 |

**TABLE 3**

| Example | Developing property | Press life in direct lithoprinting | Press life in offset printing |
|---|---|---|---|
| | | (x10,000) | (x10,000) |
| 2 | ○ | 5 | 14 |
| 3 | ○ | 6 | 15 |
| 4 | ○ | 6 | 15 |
| 5 | ○ | 5 | 14 |
| 6 | ○ | 6 | 15 |
| 7 | ○ | 6 | 15 |
| 8 | ○ | 6 | 15 |
| 9 | ○ | 6 | 15 |
| 10 | ○ | 6 | 15 |
| 11 | ○ | 6 | 15 |
| 12 | ○ | 6 | 15 |

The diazo resin-3 is a dibutylnaphthalenesulfonic acid salt of the condensate of p-diazodiphenylamine and formaldehyde. The diazo resin-4 is an octylnaphthalenesulfonic acid salt of the condensate of p-diazodiphenylamine and formaldehyde. The diazo resin-5 is a tetrafluoroboric acid salt of the condensate of p-diazodiphenylamine and formaldehyde. The diazo resin-6 is a dodecylbenzenesulfonic acid salt of the condensate of phenoxy resin/p-diazodiphenylamine(co-condensation ratio: 50/50) and formaldehyde. The diazo resin-7 is a hexafulorophosphoric acid salt of the condensate of phenoxy acetic acid/p-diazodiphenylamine(cocondensation ratio: 50/50) and formaldehyde. The diazo resin-8 is a mesitylenesulfonic acid salt of 4,4'-bis (methoxy) diphenyl ether/3-methoxydiphenylamine-4-diazonium (co-condensation ratio: 50/50). The diazo resin-9 is a sulfate of 4,4'-bis (methoxy) diphenyl ether/3-methoxydiphenylamine-4-diazonium (co-condensation ratio: 50/50).

### EXAMPLES 13 TO 21

Printing plates were produced using the diazo resin of Example 1 and the polyurethane resins of Synthesis Examples 2 to 12 in the same manner as in Example 1. The developing property in the high temperature and humidity thermostatic chamber and press life in direct lithoprinting and offset printing were examined. The results obtained are shown in Tables 4 and 5 below.

**TABLE 4**

| | Diazo resin (a) | | Diazo resin (b) | | Polyurethane resin | |
|---|---|---|---|---|---|---|
| Ex. | Kind | Amount(g) | Kind | Amount(g) | Kind | Amount(g) |
| 13 | 1 | 0.35 | 2 | 0.15 | 2 | 5.00 |
| 14 | 1 | 0.35 | 2 | 0.15 | 3 | 5.00 |
| 15 | 1 | 0.35 | 2 | 0.15 | 4 | 5.00 |
| 16 | 1 | 0.35 | 2 | 0.15 | 5 | 5.00 |
| 17 | 1 | 0.35 | 2 | 0.15 | 6 | 5.00 |
| 18 | 1 | 0.35 | 2 | 0.15 | 7 | 5.00 |
| 19 | 1 | 0.35 | 2 | 0.15 | 8 | 5.00 |
| 20 | 1 | 0.35 | 2 | 0.15 | 9 | 5.00 |
| 21 | 1 | 0.35 | 2 | 0.15 | 10 | 5.00 |

**TABLE 5**

| Example | Developing property | Press life in direct lithoprinting | Press life in zoffset printing |
|---|---|---|---|
| | | (x10,000) | (x10,000) |
| 13 | ○ | 6 | 15 |
| 14 | ○ | 6 | 15 |
| 15 | ○ | 6 | 15 |
| 16 | ○ | 6 | 15 |
| 17 | ○ | 6 | 15 |
| 18 | ○ | 6 | 15 |
| 19 | ○ | 6 | 15 |
| 20 | ○ | 6 | 15 |
| 21 | ○ | 6 | 15 |

### SYNTHESIS EXAMPLES 12 TO 14

### Polyurethane of Comparative Example:

The polyurethane resins used in Comparative Example 1 were synthesized using diisocyanate compounds and the diol compounds shown in Table 6 below in the same manner as in Synthesis Example 1. The molecular weights and acid values were determined in the same manner as in Synthesis Examples 1 to 11. The results obtained are shown in Table 6 below.

**TABLE 5**

| Polyurethane resin | Diisocyanate compound used | Diol compound used | Acid value weight dispersion | Molecular | Degree of |
|---|---|---|---|---|---|
| | (mol%) | (mol%) | (meq/g) | (x10⁴) | |
| 11 | (1) + (2) (70) (30) | (1) + (2) (60) (40) | 1.59 | 6.4 | 4.2 |
| 12 | (1) + (2) (100) (0) | (1) + (2) (60) (40) | 1.61 | 7.3 | 4.0 |
| 13 | (1) + (2) (70) (30) | (1) + (2) (20) (80) | 1.15 | 7.5 | 4.6 |
| 14 | (1) + (2) (70) (30) | (1) + (2) (100) (0) | 1.75 | 7.3 | 4.5 |

### SYNTHESIS EXAMPLE 15

### Polyurethane Resin of JP-A-62-123453, Example 1:

To 500 ml three-necked round-bottomed flask equipped with a condenser and a stirrer were added 125 g (0.50 mol) of 4,4'-diphenylmethane diisocyanate and 67 g (0.50 mol) of 2,2-bis(hydroxymethyl)propionic acid , which were dissolved in dioxane. 1 g of N,N-diethylaniline as a catalyst was further added thereto. The resulting mixture was refluxed under heating and stirring for 6 hours. The reaction mixture thus obtained was introduced into a solution of 4 liters of water and 40 ml of acetic acid with stirring to precipitate white polymer. This polymer was filtered off and washed with water, followed by drying under vacuum, thereby obtaining 185 g of a polymer.

The molecular weight of the polymer was determined by gel permeation chromatography (GPC). As the result, it was found to be 28,000 in terms of weight average molecular weight (polystyrene basis). Further, the carboxyl group content was determined by titration. It was found to be 2.47 meg/g.

Further, this polymer was placed into 300 ml three-necked round-bottomed flask equipped with a condenser and a stirrer, and dissolved with 200 ml of DMF. 6.3 g (0.062 mol) of triethyl amine was added to this solution, and the resulting mixture was heated at 80°C. 7.7 g (0.062 mol) of ethylene bromohydrin was added dropwise thereto with stirring over 10 minutes. Stirring was then continued for 2 hours.

After completion of the reaction, the reaction mixture thus obtained was added to 4 liters of water and 200 ml of acetic acid with stirring to precipitate a white polymer. This polymer was filtered off and washed with water, followed by drying under vacuum, thereby obtaining 42 g of the polymer.

It was confirmed by MNR determination that a hydroxyethyl group was introduced into a carboxyl group. Further, the remaining carboxyl group content was determined by titration, and it was found to be 1.21 meq/g.

### COMPARATIVE EXAMPLES 1 TO 9

Printing plates were produced using diazo resins other than those of the present invention and the polyurethane resin of Example 1 in the same manner as in Example 1. The developing property in the high temperature and humidity thermostatic chamber and press life in direct lithoprinting and offset printing were examined. The results obtained are shown in Tables 7 and 8.

**TABLE 7**

| Com. | Diazo resin (a) | | Diazo resin (b) | | Polyurethane resin | |
|---|---|---|---|---|---|---|
| Ex. | Kind | Amount(g) | Kind | Amount(g) | Kind | Amount(g) |
| 1 | 1 | 0.50 | - | | 1 | 5.00 |
| 2 | 5 | 0.50 | - | | 1 | 5.00 |
| 3 | 7 | 0.50 | - | | 1 | 5.00 |
| 4 | 9 | 0.50 | - | | 1 | 5.00 |
| 5 | - | | 2 | 0.50 | 1 | 5.00 |
| 6 | - | | 3 | 0.50 | 1 | 5.00 |
| 7 | - | | 4 | 0.50 | 1 | 5.00 |
| 8 | - | | 6 | 0.50 | 1 | 5.00 |
| 9 | - | | 8 | 0.50 | 1 | 5.00 |

**TABLE 8**

| Comparative Example | Developing property | Pess life in direct lithoprinting | Press life in offset printing |
|---|---|---|---|
| | | (x10,000) | (X10,000) |
| 1 | Δ | 2 | 5 |
| 2 | Δ | 2 | 5 |
| 3 | Δ | 2 | 5 |
| 4 | Δ | 2 | 5 |
| 5 | ○ | 1 | 8 |
| 6 | ○ | 1 | 8 |
| 7 | ○ | 1 | 8 |
| 8 | ○ | 1 | 6 |
| 9 | ○ | 1 | 6 |

Developing property "Δ" shows that the diazo resin remains in a non-image area so that the non-image area is colored yellow.

### COMPARATIVE EXAMPLES 10 TO 15

Printing plates were produced using a diazo resin of the present invention and the polyurethane resins other than those of the present invention in the same manner as in Example 1. The developing property in the high temperature and humidity thermostatic chamber and press life in direct lithoprinting and offset printing were examined. The results obtained are shown in Tables 9 and 10.

**TABLE 9**

| Com. | Diazo resin (a) | | Diazo resin (b) | | Polyurethane resin | | Binder | |
|---|---|---|---|---|---|---|---|---|
| Ex. | Kind | Amount(g) | Kind | Amount(g) | Kind | Amount(g) | Kind | Amount(g) |
| 10 | 1 | 0.35 | 2 | 0.15 | 11 | 5.00 | - | - |
| 11 | 1 | 0.35 | 2 | 0.15 | 12 | 5.00 | - | - |
| 12 | 1 | 0.35 | 2 | 0.15 | 13 | 5.00 | - | - |
| 13 | 1 | 0.35 | 2 | 0.15 | 14 | 5.00 | - | - |
| 14 | 1 | 0.35 | 2 | 0.15 | - | - | 1 | 5.00 |
| 15 | 1 | 0.35 | 2 | 0.15 | - | - | 2 | 5.00 |

**TABLE 10**

| Comparative Example | Developing property | Pess life in direct lithoprinting | Press life in offzset printing |
|---|---|---|---|
| | | (x10,000) | (x10,000) |
| 10 | ○ | 1 | 3 |
| 11 | x | 6 | 3 |
| 12 | x | 4 | 8 |
| 13 | ○ | 1 | 2 |
| 14 | ○ | 2 | 5 |
| 15 | ○ | 2 | 6 |

Developing property "x" shows that the binder and the dye remain on a non-image area so that the non-image area is colored blue.

Binder-1 is a 2-hydroxyethyl methacrylate/acrylonitrile/ methyl methacrylate/methacrylic acid copolymer (weight ratio: 50/20/26/4, average molecular weight: 75,000, acid value: 0.4 meq/g).

Binder-2 is a 2-hydroxyethyl methacrylate/acrylonitrile/ethyl methacrylate/methacrylic acid copolymer (weight ratio: 45/15/36/4, average molecular weight: 120,000, acid value: 0.4 meq/g).

## Claims

1. A photosensitive composition comprising a diazo resin (a) wherein a counter anion is an inorganic acid anion or an aliphatic organic acid anion having 3 or less carbon atoms; a diazo resin (b) wherein a counter anion is an aliphatic or aromatic organic acid anion having 6 or more carbon atoms; and a polyurethane resin which is a reaction product of an isocyanate comprising 40 to 90 mol% of a diisocyanate represented by the general formula (I) based on the amount of total isocyanate components with an alcohol comprising 30 to 90 mol% of a diol represented by the general formula (II) based on the amount of total alcohol components; 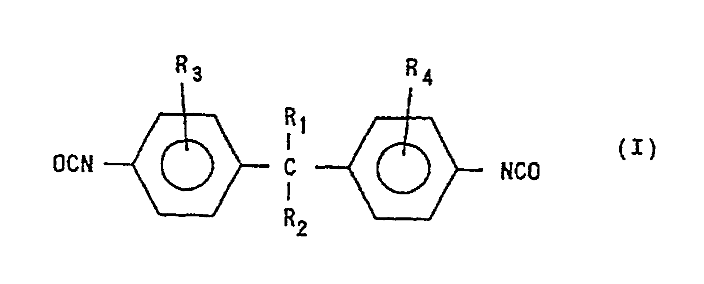 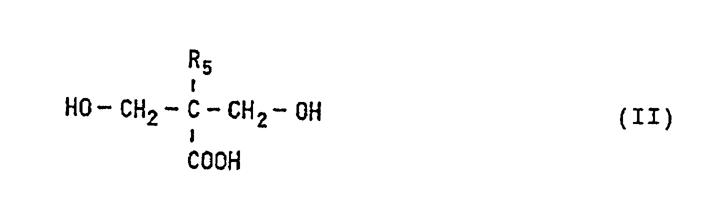 wherein R₁, R₂, R₃ and R₄ may be the same or different and each represent a hydrogen atom, an alkyl group having 1 to 4 carbon atoms, an alkoxy group having 1 to 6 carbon atoms or a halogen atom, and R₅ represents a hydrogen atom or an alkyl group having 1 to 8 carbon atoms.

2. The photosensitive composition as claimed in claim 1, wherein an acid for forming a counter anion of the diazo resin (a) is hexafluorophosphoric acid or tetrafluoroboric acid, and an acid for forming a counter anion of the diazo resin (b) is dodecylbenzenesulfonic acid, dibutylnaphthalenesulfonic acid or octylnaphthalenesulfonic acid.

3. The photosensitive composition as claimed in claim 1, wherein a weight ratio of the diazo resin (a) to the diazo resin (b) is 0.1 : 0.9 to 0.9 : 0.1.

## Patentansprüche

1. Lichtempfindliche Zusammensetzung, umfassend ein Diazoharz (a), worin ein Gegenanion ein anorganisches Säureanion oder ein aliphatisches organisches Säureanion mit 3 oder weniger Kohlenstoffatomen ist; ein Diazoharz (b), worin ein Gegenanion ein aliphatisches oder aromatisches organisches Säureanion mit 6 oder mehr Kohlenstoffatomen ist; und ein Polyurethanharz, das ein Reaktionsprodukt eines Isocyanats, umfassend 40 bis 90 mol-% eines Diisocyanats, dargestellt durch die allgemeine Formel (I), basierend auf der Menge der gesamten Isocyanatkomponenten, mit einem Alkohol, umfassend 30 bis 90 mol-% eines Diols, dargestellt durch die allgemeine Formel (II), basierend auf der Menge der gesamten Alkoholkomponenten, ist; 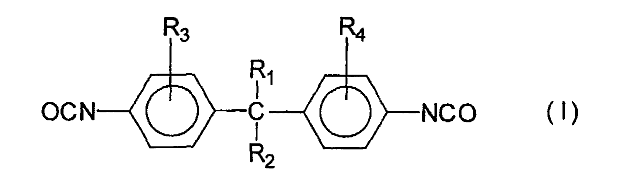 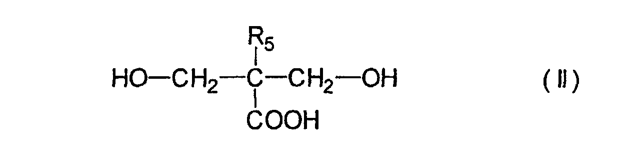 worin R₁, R₂, R₃ und R₄ gleich oder verschieden sein können und jeweils ein Wasserstoffatom, eine Alkylgruppe mit 1 bis 4 Kohlenstoffatomen, eine Alkoxygruppe mit 1 bis 6 Kohlenstoffatomen oder ein Halogenatom darstellen und R₅ ein Wasserstoffatom oder eine Alkylgruppe mit 1 bis 8 Kohlenstoffatomen darstellt.

2. Lichtempfindliche Zusammensetzung gemäss Anspruch 1, worin eine Säure zum Bilden eines Gegenanions des Diazoharzes (a) Hexafluorphosphorsäure oder Tetrafluorborsäure ist, und eine Säure zum Bilden eines Gegenanions des Diazoharzes (b) Dodecylbenzolsulfonsäure, Dibutylnaphthalinsulfonsäure oder Octylnaphthalinsulfonsäure ist.

3. Lichtempfindliche Zusammensetzung gemäss Anspruch 1, worin das Gewichtsverhältnis des Diazoharzes (a) zu dem Diazoharz (b) 0,1:0,9 bis 0,9:0,1 ist.

## Revendications

1. Une composition photosensible comprenant une résine diazo (a) dans laquelle un contre-anion est un anion d'acide minéral ou un anion d'acide organique aliphatique ayant 3 atomes de carbone ou moins ; une résine diazo (b) dans laquelle un contre-anion est un anion d'acide organique aliphatique ou aromatique ayant 6 atomes de carbone ou davantage ; et une résine polyuréthane qui est le produit de réaction d'un isocyanate comprenant de 40 à 90% en moles d'un diisocyanate représenté par la formule générale (I) sur la base de la quantité des composés isocyanates totaux avec un alcool comprenant de 30 à 90% en moles d'un diol représenté par la formule générale (II) sur la base de la quantité des composés alcools totaux; 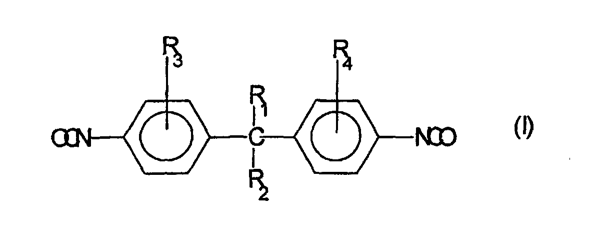 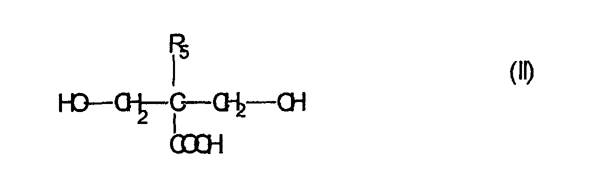 dans laquelle R₁, R₂, R₃ et R₄ peuvent être identiques ou différents et chacun représente un atome d'hydrogène, un groupe alkyle ayant de 1 à 4 atomes de carbone, un groupe alcoxy ayant de 1 à 6 atomes de carbone ou un atome d'halogène, et R₅ représente un atome d'hydrogène ou un groupe alkyle ayant de 1 à 8 atomes de carbone.

2. La composition photosensible telle que revendiquée dans la revendication 1, dans laquelle un acide pour former un contre-anion de la résine diazo (a) est l'acide hexafluorophosphorique ou l'acide tétrafluoroborique, et un acide pour former un contre-anion de la résine diazo (b) est l'acide dodecylbenzenesulfonique, l'acide dibutylnaphtalenesulfonique ou l'acide octylnaphtalenesulfonique.

3. La composition photosensible telle que revendiquée dans la revendication 1, dans laquelle un rapport en poids de la résine diazo (a) à la résine diazo (b) est de 0,1 : 0,9 à 0,9 : 0,1.
